# EUROPÄISCHE PATENTANMELDUNG

(11) **EP 4 667 673 A1**
(43) Veröffentlichungstag der Anmeldung: **24.12.2025**
(21) Anmeldenummer: 25173516.3
(22) Anmeldetag: 30.04.2025
(51) Int. Cl.: E04C 2/04, E04B 1/16, E04C 2/34, B28B 23/00, E04B 5/32, E04C 5/20

(54) **FERTIGTEIL-BAUTEIL AUS BETON SOWIE VERFAHREN ZUR HERSTELLUNG**

(30) Priorität: 20.06.2024 AT 505042024
(71) Anmelder: Baumit Beteiligungen GmbH, 2754 Waldegg (AT)
(72) Erfinder: Weißmann, Peter, 2754 Waldegg (AT); Artner, Eduard, 4040 Linz (AT)
(74) Vertreter: Müllner, Martin

(57) **Zusammenfassung**

Ein Fertigteil-Bauteil, bestehend aus zwei zueinander parallelen Beton-Fertigteilplatten (11, 12), die mit Gitterträgern (14) voneinander distanziert sind und in deren Zwischenraum Beton (13) eingegossen ist, weist erfindungsgemäß im Zwischenraum Hohlkörper (15) auf, deren Wand aus Beton besteht. Die Hohlkörper (15) sind vorzugsweise im 3D-Druck hergestellt.

## Beschreibung

### Technisches Gebiet

Die vorliegende Erfindung betrifft ein Fertigteil-Bauteil, bestehend aus zwei zueinander parallelen Beton-Fertigteilplatten, die voneinander distanziert sind und in deren Zwischenraum erst bauseits Beton eingegossen wird. Sie betrifft auch Verfahren zur Herstellung solcher Fertigteil-Bauteile.

Die in der Erfindung beschriebenen Fertigteil-Bauteile umfassen insbesondere Wände und Decken.

### Stand der Technik

Aktuelle, dem Stand der Technik entsprechende Fertigteil-Bauteile bestehen aus zwei Beton-Fertigteilplatten mit Bewehrungsgittern und werden liegend mit folgendem Herstellprozess in Fertigteilwerken produziert:

Auf dem Schaltisch werden das horizontale Bewehrungsgitter und Gitterträger mit Abstandshaltern fixiert, und im Anschluss wird Beton eingegossen, wodurch die erste Beton-Fertigteilplatte mit herausragenden Gitterträgern entsteht. Der Abstand zwischen den Gitterträgern ist variabel.

Wenn der Beton der ersten Beton-Fertigteilplatte erhärtet ist, wird die zweite Beton-Fertigteilplatte gegossen, die erste Beton-Fertigteilplatte umgedreht, und die herausragenden Gitterträger der ersten Platte werden in den noch frischen Beton der zweiten Beton-Fertigteilplatte versenkt. Nach dem Aushärten wird das Fertigteil-Bauteil in dieser Ausführung auf die Baustelle transportiert, und der Hohlraum des Fertigteil-Bauteils, also der Zwischenraum zwischen den beiden Beton-Fertigteilplatten, wird dann vor Ort im eingebauten Zustand mit Beton verfüllt.

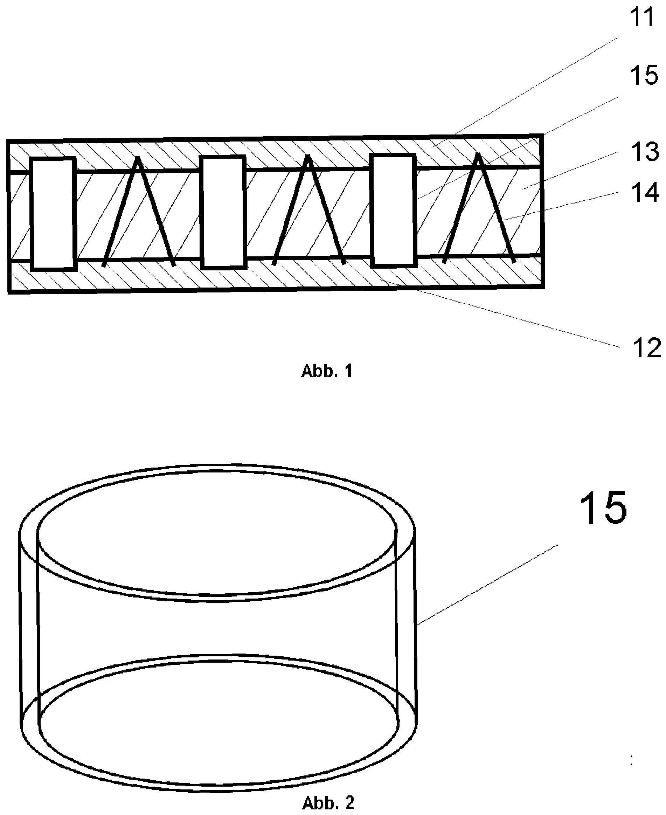

Solch ein Fertigteil-Bauteil ist z.B. in Fig. 1 der dargestellt. Die Beton-Fertigteilplatten tragen das Bezugszeichen 1, die Gitterträger das Bezugszeichen 2, und der zu verfüllende Zwischenraum trägt das Bezugszeichen 3.

Nun ist aber das vollständige Verfüllen des Zwischenraums mit Beton in Bezug auf die Statik oder schalltechnische Anforderungen nicht immer bzw. nicht überall notwendig.

In der erwähnten , Fig. 2 wurde bereits vorgeschlagen, zwischen den Beton-Fertigteilplatten Schalungselemente aus Streckmetall vorzusehen, die an ihren Rändern in die Beton-Fertigteilplatten eingegossen sind. Diese Schalungselemente begrenzen den Raum, in den Beton eingefüllt werden kann, und sorgen dafür, dass Hohlräume verbleiben.

Diese Lösung hat aber mehrere Nachteile. Die zwischen den Streckmetall-Schalungselementen verbleibenden Kanäle bilden durchgehende statische Schwachstellen.

Weiters ist bei dieser Lösung das Recyclen schwierig, weil sich bei konventionellen Aufbereitungsverfahren der Beton vom Streckmetall nur mit hohem Aufwand trennen lässt.

Die Streckmetalle müssen in standardisierten Größen/Geometrien vorgefertigt werden, was mit entsprechenden Vorlaufzeiten verbunden ist. Insbesondere sind für unterschiedliche Bauteil- bzw. Wanddicken und -geometrien angepasste unterschiedliche Streckmetall-Schalungselemente notwendig, die vorgefertigt werden müssen, was entweder eine entsprechende Vorlaufzeit erfordert oder die Lagerhaltung von vielen unterschiedlichen Teilen notwendig macht.

### Kurzbeschreibung der Erfindung

Es ist Aufgabe der vorliegenden Erfindung, ein innovatives, gewichtsreduziertes Fertigteil-Bauteil zu beschreiben, das diese Nachteile nicht aufweist.

Diese Aufgabe wird durch ein Fertigteil-Bauteil der eingangs genannten Art erfindungsgemäß dadurch gelöst, dass im Zwischenraum Hohlkörper fixiert sind, deren Wand aus Beton oder Mörtel besteht, bevorzugt ist, dass die Hohlkörper mittels 3D-Druckverfahren aus mineralischem 3D-Druckmaterial hergestellt sind. Unter 3D-Druckmaterial wird Beton oder Mörtel verstanden.

Dadurch ergeben sich mehrere Vorteile. Die Fertigteil-Bauteile mit den Hohlkörpern aus Beton oder Mörtel sind deutlich einfacher zu recyceln, auch wenn sie mittels 3D-Druck hergestellt sind, denn das 3D-Druckmaterial kann von der stofflichen Zusammensetzung einem Beton gleichgesetzt werden. Mit Hohlkörpern ausgeführte Betonbauteile können daher mit einfachen Recyclingprozessen wiederaufbereitet werden. Es ist keine spezielle Trennung notwendig, weder vom Beton der Beton-Fertigteilplatten noch vom Ortbeton, der zwischen die Beton-Fertigteilplatten gegossen wurde.

Weiters haben die 3D-gedruckten Beton-Hohlkörper gegenüber Streckmetall umwelt- bzw. klimatechnische Vorteile: Wenn man davon ausgeht, dass die Hohlkörper aus 3D-Druckmörtel in dem Fertigteil-Bauteil das gleiche Volumen an Ortbeton verdrängen, ist die Gesamtmenge an eingespartem Beton gleich wie bei der Lösung mit Streckmetall. Erfahrungsgemäß weist der 3D-Druckmörtel ein nur unwesentlich höheres GWP (GWP = Global Warming Potential; dieses liegt in einem Bereich von ca. 200 ± 80 kg CO₂/t Material) auf als der den Hohlkörper umgebende Ortbeton (je nach Betonsorte ca. 80-100 kg CO₂/t Material). Durch den Einbau von Hohlkörpern aus Streckmetall erhöht sich das GWP des Fertigteil-Bauteils durch den hohen CO₂-Output des eingebauten Streckmetalls deutlich. Dieses liegt in einem Bereich von über 2500 kg CO_{2/}t und ist damit um ca. den Faktor 10 höher als bei 3D-Druckmörtel. Der sehr hohe CO₂-Output von Streckmetall wirkt sich negativ auf die Gesamt-CO₂-Bilanz des Fertigteil-Bauteils aus, weil das GWP, welches durch eingesparten Verfüllbeton reduziert wird, durch die hohen CO₂-Emissionen von Streckmetall wieder negativ beeinflusst wird und die CO₂-Einsparung sich somit deutlich reduziert. Dieser Effekt fällt beim 3D-Druckmörtel nur sehr gering aus, wodurch bei Hohlkörpern aus 3D-Druckmörtel im Vergleich zu aus Streckmetall gefertigten, deutlich mehr CO₂ eingespart werden kann.

Es ist weiters möglich, die Hohlkörper mit klinkerreduziertem Zement (auch beim 3D-Druck) herzustellen, was zu einer weiteren Senkung des CO₂-Outputs führt.

Die Möglichkeit, die Hohlkörper individuell je nach Belastungsfall im Bauteil (geringe vs. hohe Krafteinwirkung) in frei wählbaren Geometrien sowie auf das optimale Volumen des Hohlkörpers angepasst direkt bei der Fertigung der Hohlwände mittels 3D-Drucks zu produzieren und platzieren, bringt eine extreme Flexibilität und ist ein zusätzlicher Vorteil dieser Bauweise. D.h. es ist erfindungsgemäß eine hochindividualisierbare und CO₂-optimierte *in situ*-Produktion des Fertigteil-Bauteils möglich.

Wenn die Hohlkörper mittels 3D-Druckverfahren aus mineralischem 3D-Druckmaterial hergestellt sind, ergeben sich weitere Vorteile. Durch die Möglichkeit von flexibel dimensionierbaren 3D-Druck-Hohlkörpern sind Fertigteil-Bauteildicken (Abstand zwischen den Fertigteilplatten) frei wählbar, da die Hohlkörper auch in Bezug auf deren Höhe je nach Anforderung produziert werden können. Dies ist mit der Streckmetall-Variante nicht in dieser Flexibilität möglich, da die Hohlkörper für unterschiedliche Bauteildicken vorgefertigt werden müssen, was eine aufwändige Lagerhaltung von vielen unterschiedlichen Teilen nötig macht. Beim 3D-Druck benötigt man hingegen keinerlei oder nur eine minimale Lagerhaltung und kann die Hohlteile immer individuell und extrem kurzfristig auf die zu produzierenden Fertigteil-Bauteildimensionen abgestimmt drucken.

Prinzipiell können auch Kanäle gebildet werden, die nicht mit Ortbeton verfüllt werden, so wie dies aus der bekannt ist. Bevorzugt ist jedoch ein segmentmäßiges Einbauen der 3D-gedruckten Hohlkörper, dies bringt eine höhere Stabilität mit sich.

Weiters ist der Haftverbund zwischen dem 3D-Mörtel und Beton (Fertigteilplatte) signifikant besser als zwischen Streckmetall und Beton, was wiederum Vorteile in Bezug auf die Stabilität des Fertigteil-Bauteils mit sich bringt. Auch der Verbund zwischen Füllbeton und der "geriffelten" Oberfläche (durch das Filamentdruckverfahren) des 3D-gedruckten Hohlkörpers ist gemäß vielen internen Versuchen mit 3D-Beton bzw. 3D-Mörtel ausgezeichnet.

Wenn Kanäle gebildet werden, dann kann man deren Wände auch in einer Wellstruktur ausführen, um eine höhere Stabilität bzw. Verstärkung zu bewirken, was mit Streckmetall nicht so einfach möglich ist, hierzu müsste man das Streckmetall zuvor mit einer speziellen Vorrichtung entsprechend biegen.

Ein weiterer Vorteil ergibt sich, wenn in den 3D-gedruckten Hohlkörpern eine Faserbewehrung oder eine Seilbewehrung integriert ist. Dadurch können die Hohlkörper zusätzlich auch eine Bewehrungsfunktion übernehmen, d.h. zum Beispiel Kräfte während der Verfüllung von Ortbeton aufnehmen bzw. eine statische Funktion nach Einbau der fertigen Bauteilkonstruktion übernehmen.

Besonders bevorzugt ist es in diesem Fall, dass auch im eingegossenen Beton eine Faserbewehrung integriert ist und dass die Beton-Fertigteilplatten armierungsfrei sind. Somit können die Fertigteil-Bauteile frei von Eisen sein, es sind weder Armierungen in den Fertigteilplatten noch Gitterträger für die Distanzierung der Fertigteilplatten notwendig.

Zur Herstellung von Fertigteil-Bauteilen mit 3D-gedruckten Hohlkörpern können zwei Verfahren angewendet werden:
- Es ist möglich, dass 3D-gedruckte Hohlkörper vorgefertigt werden und bei der Herstellung der ersten Beton-Fertigteilplatte in diese versenkt bzw. auf dieser platziert werden, während die erste Beton-Fertigteilplatte noch nicht vollständig ausgehärtet ist, dass man die erste Beton-Fertigteilplatte und die Hohlkörper aushärten lässt, dass während der Herstellung der zweiten Beton-Fertigteilplatte die in der ersten Beton-Fertigteilplatte integrierten Hohlkörper, nachdem die erste Beton-Fertigteilplatte umgedreht wurde, in die noch nicht vollständig ausgehärtete zweite Beton-Fertigteilplatte versenkt bzw. auf dieser platziert werden, dass die so verbundenen Beton-Fertigteilplatten nach dem Aushärten zur Baustelle transportiert und dort aufgestellt werden und dass schließlich vor Ort Beton zwischen die Beton-Fertigteilplatten gegossen bzw. verfüllt wird.
- Alternativ dazu ist es möglich, dass bei der Herstellung der ersten Beton-Fertigteilplatte die Hohlkörper mittels additivem Fertigungsprozess in diese eingedruckt werden, während diese noch nicht vollständig ausgehärtet ist, oder auf die erste Beton-Fertigteilplatte gedruckt werden, nachdem sie ausgehärtet ist, dass man die erste Beton-Fertigteilplatte und die Hohlkörper aushärten lässt, dass während der Herstellung der zweiten Beton-Fertigteilplatte die in der ersten Beton-Fertigteilplatte integrierten Hohlkörper, nachdem die erste Beton-Fertigteilplatte umgedreht wurde, in die noch nicht vollständig ausgehärtete zweite Beton-Fertigteilplatte versenkt bzw. auf dieser platziert werden, dass die so verbundenen Beton-Fertigteilplatten nach dem Aushärten zur Baustelle transportiert und dort aufgestellt werden und dass schließlich vor Ort Beton zwischen die Beton-Fertigteilplatten gegossen bzw. verfüllt wird.

### Kurze Beschreibung der Zeichnungsfiguren

Anhand der beiliegenden Zeichnungen wird die vorliegende Erfindung näher erläutert. Es zeigt: Fig. 1 ein Fertigteil-Bauteil gemäß der vorliegenden Erfindung im Schnitt; und Fig. 2 einen Hohlkörper, wie er gemäß Fig. 1 verwendet ist, in perspektivischer Ansicht.

### Beschreibung der Ausführungsarten

Das Fertigteil-Bauteil hat außen zwei Fertigteilplatten 11, 12, die durch Gitterträger 14 miteinander verbunden sind. Zwischen den Gitterträgern 14 befinden sich Hohlkörper 15, die insbesondere durch ein 3D-Druckverfahren mit mineralischem Druckmörtel hergestellt sein können. Der Zwischenraum zwischen den Fertigteilplatten 11, 12 ist mit Ortbeton 13 ausgefüllt, wobei wegen der Hohlkörper 15 die Bereiche innerhalb dieser Hohlkörper 15 frei bleiben. Die Hohlkörper 15 sind im Wesentlichen zylindrisch, wobei die Grundfläche bzw. die räumliche Geometrie der Hohlkörper beliebig sein kann; die Grundfläche kann (wie in Fig. 2 dargestellt) kreisförmig sein, sie kann aber auch elliptisch oder quadratisch oder rechteckig oder beliebig vieleckig sein. Da die Hohlkörper im 3D-Druckverfahren hergestellt werden, sind hier beliebige Formen möglich, sodass man je nach den jeweiligen geometrischen Gegebenheiten und statischen Anforderungen (Abstand zwischen Gitterträgern 14, Abstand zwischen den Fertigteilplatten 11, 12, statische Notwendigkeiten) eine geeignete Form wählen kann.

In einer weiteren Ausführungsform fungieren die 3D-gedruckten Hohlkörper 15 zwischen den Beton-Fertigteilplatten als Bewehrung, und es kann auf die Verwendung der Gitterträger 14 verzichtet werden. In diesem Fall wird besonders zugfester 3D-Beton bzw. 3D-Mörtel verwendet oder im 3D-Druckbeton bzw. -mörtel eine Bewehrung integriert, z.B. durch Fasern (Kurzschnitt) oder seil-, schnur-, faden- bzw. kettenförmige Bewehrungen, die während des 3D-Drucks innerhalb der Beton- bzw. Mörtelfilamente abgelegt werden, wie dies aus bekannt ist.

In einer weiteren Ausführungsform wird dem Verfüll- bzw. Ortbeton eine Faserbewehrung zugesetzt, wodurch auf die Verwendung von Bewehrungsgittern in den Fertigteilplatten verzichtet werden kann.

## Patentansprüche

1. Fertigteil-Bauteil, bestehend aus zwei zueinander parallelen Beton-Fertigteilplatten (11, 12), die voneinander distanziert sind und in deren Zwischenraum Beton (13) erst bauseits eingegossen wird, **dadurch gekennzeichnet, dass** im Zwischenraum Hohlkörper (15) fixiert sind, deren Wand aus Beton oder Mörtel besteht.

2. Fertigteil-Bauteil nach Anspruch 1, **dadurch gekennzeichnet, dass** die Hohlkörper (15) mittels 3D-Druckverfahren aus mineralischem 3D-Druckmaterial hergestellt sind.

3. Fertigteil-Bauteil nach Anspruch 2, **dadurch gekennzeichnet, dass** in den 3D-gedruckten Hohlkörpern (15) eine Faserbewehrung oder eine Seilbewehrung integriert ist.

4. Fertigteil-Bauteil nach Anspruch 3, **dadurch gekennzeichnet, dass** im eingegossenen Beton eine Faserbewehrung integriert ist und dass die Beton-Fertigteilplatten (11, 12) armierungsfrei sind.

5. Verfahren zur Herstellung eines Fertigteil-Bauteils nach einem der Ansprüche 2 bis 4, **dadurch gekennzeichnet, dass** 3D-gedruckte Hohlkörper (15) vorgefertigt werden und bei der Herstellung der ersten Beton-Fertigteilplatte (11) in diese versenkt bzw. auf dieser platziert werden, während die erste Beton-Fertigteilplatte (11) noch nicht vollständig ausgehärtet ist, dass man die erste Beton-Fertigteilplatte (11) und die Hohlkörper (15) aushärten lässt, **dass** während der Herstellung der zweiten Beton-Fertigteilplatte (12) die in der ersten Beton-Fertigteilplatte (11) integrierten Hohlkörper (15), nachdem die erste Beton-Fertigteilplatte (11) umgedreht wurde, in die noch nicht vollständig ausgehärtete zweite Beton-Fertigteilplatte (12) versenkt bzw. auf dieser platziert werden, **dass** die so verbundenen Beton-Fertigteilplatten (11, 12) nach dem Aushärten zur Baustelle transportiert und dort aufgestellt werden **und dass** schließlich vor Ort Beton (15) zwischen die Beton-Fertigteilplatten (11, 12) gegossen bzw. verfüllt wird.

6. Verfahren zur Herstellung eines Fertigteil-Bauteils nach einem der Ansprüche 2 bis 4, **dadurch gekennzeichnet, dass** bei der Herstellung der ersten Beton-Fertigteilplatte (11) die Hohlkörper mittels additivem Fertigungsprozess in diese eingedruckt werden, während diese noch nicht vollständig ausgehärtet ist, oder auf die erste Beton-Fertigteilplatte (11) gedruckt werden, nachdem sie ausgehärtet ist, **dass** man die erste Beton-Fertigteilplatte (11) und die Hohlkörper (15) aushärten lässt, **dass** während der Herstellung der zweiten Beton-Fertigteilplatte (12) die in der ersten Beton-Fertigteilplatte (11) integrierten Hohlkörper (15), nachdem die erste Beton-Fertigteilplatte (11) umgedreht wurde, in die noch nicht vollständig ausgehärtete zweite Beton-Fertigteilplatte (12) versenkt bzw. auf dieser platziert werden, **dass** die so verbundenen Beton-Fertigteilplatten (11, 12) nach dem Aushärten zur Baustelle transportiert und dort aufgestellt werden **und dass** schließlich vor Ort Beton (15) zwischen die Beton-Fertigteilplatten (11, 12) gegossen bzw. verfüllt wird.
